# EUROPEAN PATENT APPLICATION

(11) **EP 4 064 362 A1**
(43) Date of publication of application: **28.09.2022**
(21) Application number: 21163984.4
(22) Date of filing: 22.03.2021
(51) Int. Cl.: H01L 29/06, H01L 29/78, H01L 29/08, H01L 29/10, H01L 29/739

(54) **POWER SEMICONDUCTOR DEVICE**

(71) Applicant: Hitachi Energy Switzerland AG, 5400 Baden (CH)
(72) Inventor: MIHAILA, Andrei, 5415 Rieden (CH); RAHIMO, Munaf, 4716 Gänsbrunnen (CH); KNOLL, Lars, 5607 Hägglingen (CH); BELLINI, Marco, 8952 Schlieren (CH)
(74) Representative: Epping - Hermann - Fischer

(57) **Abstract**

A power semiconductor device (1) is provided, comprising
- a drift layer (2) of a first conductivity type,
- at least two well regions (3) of a second conductivity type being different from the first conductivity type, and
- at least one intermediate region (4), wherein
- the at least two well regions (3) and the at least one intermediate region (4) are provided within the drift layer (2) at a first side,
- the at least one intermediate region (4) is provided between the at least two well regions (3), and
- the at least one intermediate region (4) comprises at least one first doped region (5) of the first conductivity type and at least one second doped region (6) of the second conductivity type.

## Description

The invention relates to a power semiconductor device.

Typically, power semiconductor devices, such as silicon carbide metal oxide semiconductor field-effect transistors, SiC MOSFETs for short, are exemplarily configured to have reduced switching losses when compared to similarly rated silicon insulated gate bipolar transistors, Si IGBTs for short. Considering transportation or e-mobility applications, the end user exemplarily requests that the devices meet all required standards regarding fault condition operation, such as short-circuit capabilities, avalanche ruggedness and current overload conditions.

Embodiments of the disclosure relate to a power semiconductor device, which has an improved efficiency.

The object is achieved by the subject-matter of the independent claims. Further embodiments are evident from the dependent claims and the following description.

The first aspect of the invention relates to a power semiconductor device. The term "power" here and in the following, for example, refers to power semiconductor devices adapted for processing voltages and currents more than 100 V and/or more than 10 A.

The power semiconductor device is a MOS-based device, for example, a power metal insulating semiconductor field-effect transistor, power MISFET for short. The term MISFET shall also comprise MOSFETs (metal oxide semiconductor field-effect transistors) which have an oxide as insulating material at the gate. The power semiconductor device may also be an insulated gate insulated-gate bipolar transistor, IGBT.

Exemplarily the power MISFET comprises a wide bandgap material, which may be silicon carbide. Thus, the power semiconductor device is exemplarily embodied as a power SiC MISFET.

According to the embodiment of the first aspect, the power semiconductor device comprises a drift layer of a first conductivity type.

For example, the drift layer comprises a semiconductor material or consists of a semiconductor material. Exemplarily the semiconductor material is SiC. For example, the drift layer comprises first dopants. Exemplarily, the first dopants are n-type dopants. In this case, the first conductivity type is an n-type conductivity.

The drift layer has, for example, a main extension plane. For example, lateral directions are aligned parallel to the main extension plane and the vertical direction is aligned perpendicular to the main extension plane.

According to the embodiment, the power semiconductor comprises at least two well regions of a second conductivity type being different from the first conductivity type. The at least two well regions are exemplarily separated from one another in lateral directions. For example, each of the well regions extends along a main extension direction. The main extension directions of the well regions may be aligned parallel to one another.

The well regions comprise or consist of a semiconductor material, which is, for example, the same material as the semiconductor material of the drift layer. Exemplarily, the well regions comprise second dopants, such as p-type dopants. In this case, the second conductivity type is a p-type conductivity.

If the well regions are of a p-type conductivity, the drift layer is of an n-type conductivity and vice versa, since the second conductivity type is different from the first conductivity type.

Exemplarily the well regions are produced within the drift layer by a doping process. For example, the second dopants are introduced into the drift layer. Due to the introduction of the second dopants into the drift layer, the well regions are exemplarily generated.

According to the embodiment, the power semiconductor device comprises at least one intermediate region. Exemplarily, the intermediate region extends along a main extension direction. The main extension direction of the intermediate region is aligned parallel to the main extension directions of the well regions.

The intermediate region comprises or consists of a semiconductor material, which is, for example the same material as the semiconductor material of the drift layer. Exemplarily the intermediate region is produced within the drift layer by a further doping process. For example, the intermediate region is produced by introducing at least one of the first dopants or the second dopants into the drift layer. The term "at least one of the first dopants or second dopants are introduced" shall cover cases, in which either the first dopants are introduced, or the second dopants are introduced, or the first dopants and the second dopants are introduced. Such expressions shall be understood in the same way throughout the whole disclosure.

Exemplarily, a power semiconductor device, e.g. being a power SiC MISFET, with such an intermediate region has a comparatively reduced on resistance in contrast to a power SiC MISFET without having an intermediate region.

According to the embodiment of the power semiconductor device, the at least two well regions and the at least one intermediate region are provided at a first side of the power semiconductor device.

The well regions extend in vertical direction from the first side up to a first depth. The well region can have a first depth, which is shallower than the depth of the intermediate region, which acts as a junction field effect transistor, JFET, region. Alternatively, the well region can have the same depth or can be deeper than the intermediate region. Further, the intermediate region exemplarily extends from the first side up to at least one of a second depth or a third depth. For example, at least one of the second depth or the third depth are at least as deep as the first depth. Exemplary, at least one of the second depth or the third depth are as deep as the first depth. Alternatively, at least one of the second depth or the third depth is exemplarily smaller than the first depth.

For example, a first main surface at the first side of the power semiconductor device is formed flat. The first main surface extends parallel to the lateral directions. This is to say that a top surface of the well regions and a top surface of the intermediate region are part of the first main surface.

According to the embodiment of the power semiconductor device, the at least one intermediate region is provided between two of the at least two well regions. Exemplarily the intermediate region is sandwiched between two well regions. For example, the intermediate region is in direct contact to the two neighboured well regions. In this case, the top surface of the well regions and the top surface of the intermediate region terminate flush with one another.

If the first depth, the second depth and the third depth are equal, exemplarily, a bottom surface of the well regions and a bottom surface of the intermediate region terminate flush with one another.

According to the embodiment of the power semiconductor device, the at least one intermediate region comprises at least one first doped region of the first conductivity type and at least one second doped region of the second conductivity type. For example, the first doped region extends from the first side up to the second depth and the second doped region extends from the first side up to the third depth.

For example, the intermediate region comprises further first dopants and further second dopants. Exemplarily, the first doped region comprises further first dopants. For example, the further first dopants are n-type dopants. Further, the second doped region comprises exemplarily further second dopants. For example, the further second dopants are p-type dopants.

Exemplarily, the further first dopants are the same dopants as the first dopants. Further, the further second dopants are exemplarily the same dopants as the second dopants.

The further first dopants and the further second dopants are incorporated within the drift layer, e.g. by an ion implantation process.

In contrast, a prior art power SiC MOSFET having solely an intermediate region being doped with solely an n-type dopant has a reduced short-circuit capability in connection with an increased Gate-Drain capacitance, C_{GD} for short. Further, such an intermediate region being doped with solely an n-type dopant causes an increase in an electric field to which a gate oxide is subjected to, being e.g. arranged above the intermediate region.

The power semiconductor device, e.g. being a power SiC MISFET, with the intermediate region having the first and the second doped region has, inter alia, the following advantages. Due to the first doped region, the on-resistance of the power semiconductor device is reduced in contrast to a power SiC MISFET having solely an intermediate region of the first conductivity type. Further, due to the second doped region, the electric field above the intermediate region, where exemplarily a gate is arranged as described in detail below, is effectively reduced. Thus, a gate oxide being arranged e.g. above the intermediate region is protected from high electric fields.

According to at least one embodiment of the power semiconductor device, the at least one intermediate region extends along a main extension direction and the at least one first doped region and the at least one second doped region are provided consecutively along the main extension direction. For example, the first doped region and the second doped region are arranged next to one another in direct contact along the main extension direction.

According to at least one embodiment of the power semiconductor device, a maximum doping concentration of at least one of the at least one first doped region or the at least one second doped region is at least two times or at least five times higher than a maximum doping concentration of the drift layer. Exemplarily, the drift layer has a homogeneous doping concentration so that the maximum doping concentration corresponds to a mean doping concentration. Exemplary, a maximum doping concentration of at least one of the at least one first doped region or the at least one second doped region is at least one or two orders of magnitude higher than a doping maximum concentration of the drift layer.

For example, the first doped region has a maximum doping concentration being at least two times or at least five times higher than a maximum doping concentration of the drift layer. Further, the second doped region comprises exemplarily a maximum doping concentration being at least two times higher or at least five times than a maximum doping concentration of the drift layer.

According to at least one embodiment of the power semiconductor device, the maximum doping concentration of at least one of the at least one first doped region or the at least one second doped region is at least 1·14 cm⁻³ and at most 1·18 cm⁻³.

According to at least one embodiment of the power semiconductor device, a width of at least one of at least one first doped region or the at least one second doped region is at least 0.5 µm and at most 5 µm. The width is an extent of at least one of the first doped region or the second doped region perpendicular to the main extension direction of the intermediate region. Exemplarily, a distance between the at least two well regions in lateral directions is at least 0.5 µm and at most 5 µm.

Exemplarily, the on-resistance is dependent on the width of the first doped region. For example, a width of the intermediate region can be comparatively reduced in comparison to a power SiC MOSFET without having the first and the second doped region. While reducing the width a charge carrier density is increased within the first doped region and thus the on-resistance is reduced further. Exemplarily, the increased charge carrier density increases the C_{GD} as well, which can lead to an increase of the electric field above the intermediate region. Due to the second doped regions, the C_{GD} is reduced effectively, as explained in more detail below. Therefore, the electric field above the intermediate region can be effectively reduced.

A further advantage is, for example, that due to the reduced C_{GD} also the short-circuit behaviour is at least maintained in comparison to a power SiC MOSFET without having an intermediate region. For example, the power semiconductor device described here has, for example, a short-circuit capability of at least 10 ms.

According to at least one embodiment of the power semiconductor device, a length of at least one of the at least one first doped region or the at least one second doped region is at least 0.5 µm and at most 1.5 µm. For example, the length is an extent of at least one of the first doped region or the second doped region along the main extension direction of the intermediate region.

According to at least one embodiment of the power semiconductor device, a first depth of the at least two well regions is at most as large as a second depth of the at least one first doped region and as a third depth of the at least one second doped region. Each depth is an extent of at least one of the first doped region or the second doped region and the well regions in vertical direction.

It is possible that the second depth of the first doped region differs from the third depth of the second doped region. For example, the second depth of the first doped region is deeper than the third depth of the second doped region or vice versa.

According to at least one embodiment of the power semiconductor device, at least one of the second depth or the third depth are at least 50 nm and at most 1.5 µm.

According to at least one embodiment of the power semiconductor device, at least one of the at least one first doped region or at least one of the at least one second doped region are in direct contact to the at least two well regions. Exemplarily, both the first doped region and the second doped region extend over the whole width of the intermediate region and are in direct contact to the well regions.

According to at least one embodiment of the power semiconductor device, at least one of the at least one first doped region or the at least one second doped region are spaced apart in lateral directions to the least two well regions. Exemplarily, both the first doped region and the second doped region do not extend over the whole width of the intermediate region and are thus not in direct contact to the well regions.

According to at least one embodiment of the power semiconductor device, the at least one second doped region is spaced apart from the well at least two well regions in lateral directions. Exemplarily, the second doped region does not extend over the whole width of the intermediate region. This is to say that the second doped region exemplarily is spaced apart from the well regions in lateral directions.

For example, the first doped region extends between the second doped region and the well regions in lateral directions. Exemplarily, the first doped region is arranged between the second doped region and the well regions in lateral directions. In another embodiment, the drift layer extends between the second doped region and the well regions in lateral directions. Exemplarily, the drift layer is arranged between the second doped region and the well regions in lateral directions.

According to at least one embodiment of the power semiconductor device, a gate is provided on the at least one intermediate region. The gate comprises, exemplarily, a gate contact and a gate insulator. The gate contact comprises or consists of a metal. The gate insulator comprises, for example, an electrical insulating material, such as an electrical insulating oxide or high k-dielectrics. SiO₂ has a dielectric constant of 3.9 and "high k" dielectric materials are referred to as having a dielectric constant k>3.9.

For example, the gate contact is, at least in regions, externally contactable in an electrical conductive manner. Further, the gate contact is exemplarily embedded in the gate insulator. This is to say that the gate insulator covers all outer surfaces of the gate contact, except the region for external contacting.

According to at least one embodiment of the power semiconductor device, a back metal layer is provided on the drift layer at a second side opposite the first side. For example, the back metal layer is provided on a second main surface of the drift layer at the second side. For example, the back metal layer covers the second main surface completely.

The back metal layer comprises, for example, a metal or consists of a metal. For example, the back metal layer is an electrode being externally contactable in an electrical conductive manner.

Exemplarily, an overlap in plan view of the gate and the back metal layer is dependent to the width and the length of the second doped region.

A further advantage is, inter alia, that due to the second doped region, the overlap in plan view of the gate and the back metal layer is reduced in comparison to a power SiC MOSFET having no second doped region. This is to say that also the second doped regions C_{GD} is effectively reduced and thus the electric field subjected to the gate is reduced. This leads, for example, to a durable power semiconductor device.

According to at least one embodiment, the power semiconductor device further comprises at least two source regions of the first conductivity type.

The source regions comprise or consist of a semiconductor material, which is, for example, the same material as the semiconductor material of the drift layer. Exemplarily, the source regions comprise first dopants, such as n-type dopants. In this case, the first conductivity type is an n-type conductivity. Exemplary, the maximum doping concentration of the source regions is at least two or three orders of magnitude higher than a maximum doping concentration of the drift layer.

According to at least one embodiment of the power semiconductor device, at least one of the at least two source regions is provided on each of the at least two well regions. For example, each source region is embedded in one of the well regions. This is to say that outer surfaces of the source region are covered by the well region, except a top surface of the source region. Exemplarily, the top surface of the source region and the top surface of the well region terminate flush with one another.

For example, the source regions, exemplarily the top surface of the source regions, are, at least in regions, externally contactable in an electrical conductive manner.

According to at least one embodiment of the power semiconductor device, the gate overlaps with the at least two source regions at least in places in lateral directions. Exemplarily, in plan view the gate overlaps at least in regions with the intermediate region, the well regions and the source regions in lateral directions.

According to at least one embodiment of the power semiconductor device, a drain layer of the first conductivity type is arranged on the drift layer at the second side. Exemplarily, the drain layer is arranged between the drift layer and the back metal layer. For example, a maximum doping concentration of the drain layer is at least two orders of magnitude higher, exemplarily five times higher, than a maximum doping concentration of the drift layer.

The subject-matter of the invention will be explained in more detail in the following with references to exemplary embodiments which are illustrated in the attached drawings.
Figures 1 and 2 each schematically shows a sectional view of a power semiconductor device according to an exemplary embodiment.
Figure 3 schematically shows exemplarily doping concentrations of a SiC MISFET according to prior art and doping concentrations of a SiC MISFET according to an exemplary embodiment.
Figure 4 schematically shows a current voltage diagram of a SiC MISFET according to prior art and of a SiC MISFET according to an exemplary embodiment.
Figure 5 schematically shows a sectional view of a power semiconductor device according to an exemplary embodiment.

The reference symbols used in the drawings and their meaning are listed in summary form in the list of reference symbols. In principle identical parts are provided with the same reference symbols in the figures.

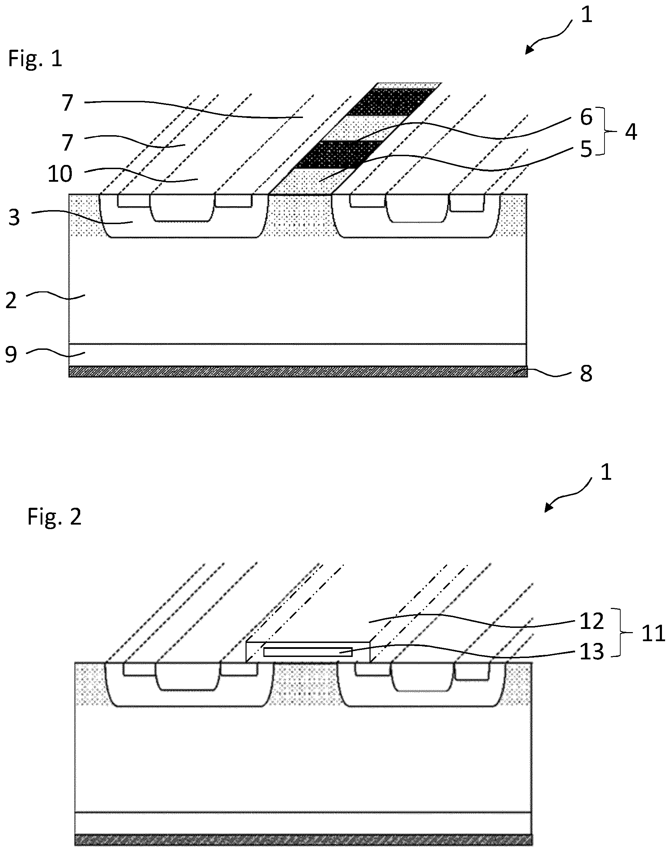

The power semiconductor device 1 according to the exemplary embodiment of Figure 1 comprises a back metal layer, a drain layer 9 and a drift layer 2 being stacked above on another in the order indicated. Adjacent layers are in direct contact to one another. The drain layer 9 and the drift layer 2 are of a first conductivity type. For example, the first conductivity type is an n-type conductivity. Exemplarily, the drift layer is an epitaxial drift layer. This is to say that the drift layer is produced, e.g., by an epitaxial process.

A maximum doping concentration of the drain layer 9 is higher than a maximum doping concentration of the drift layer 2. This is to say that the drift layer 2 is a low doped layer and the drain layer 9 is a high doped layer. The drift layer 2, as well as the drain layer 9, comprises a semiconductor material being formed of SiC. Alternatively, the semiconductor material is based on any other wideband gap material such as GaN, Al2O3 or diamond.

For example, the drain layer 9 being n-doped, can be replaced by a highly doped p-type collector layer. In this case, the power semiconductor device 1 is an IGBT.

The power semiconductor device 1 further comprises two well regions 3 of a second conductivity type being different from the first conductivity type at a first side of the drift layer 2. The first side faces away from the back metal layer 8. For example, the second conductivity type is a p-type conductivity. The well regions 3 are produced, for example, within the drift layer 2 by a doping process. For example, second dopants are introduced in the drift layer 2 and thereby generating the well regions 3 up to a first depth.

The two well regions 3 are separated from one another in lateral directions. In other words, the two well regions 3 are arranged in the drift layer 2 having a distance to one another in lateral directions. Each of the two well regions 3 extends along a main extension direction. Further, the two main extension directions of the two well regions 3 are aligned parallel to one another.

An intermediate region 4 is arranged between the two well regions 3 at the first side, also extending along a main extension direction. The main extension direction of the intermediate region 4 is parallel to the two main extension directions of the two well regions 3. The well regions 3 are produced exemplarily within the drift layer 2 by a further doping process. Thereby the intermediate region 4 is generated up to a second depth and a third depth.

Two source regions 7 of the first conductivity type are provided on each well region 3 of the second conductivity type. Exemplary, the maximum doping concentration of the source regions is at least two or three orders of magnitude higher than a maximum doping concentration of the drift layer.

Since the power semiconductor device 1 comprises two well regions 3, the power semiconductor device 1 comprises four source regions 7. Two source regions 7 being provided on one of the well regions 3 are arranged spaced apart from one another in lateral directions. In other words, the two source regions 7 arranged in each well region 3 have a distance to one another in lateral directions. Further, each of the two source regions 7 extends along a main extension direction. The two main extension directions of the two source regions 7 are aligned parallel to one another and are aligned parallel to the main extension directions of the well regions 3.

A plug 10 of the second conductivity type may be arranged between the two source regions 7 in each of the well region 3s, wherein the plug 10 also extends along a main extension direction. The main extension direction of the plug 10 is parallel to the two main extension directions of the two source regions 7. The plug 10 may have a maximum doping concentration being at least three times higher than a maximum doping concentration of the well region 3.

The plug 10 is produced exemplarily within the well region 3 by a further doping process. The plug 10 may be provided on the well region 3 with a depth smaller than the first depth of the well region 3. The plug 10 may also have a depth, which is the same as the depth of the well region 3 or the plug 10 may have a larger depth than of the well region 3.

A top surface of the well regions 3, a top surface of the source regions 7, a top surface of the plug 10 and a top surface of the intermediate region 4 are arranged within a common plane.

Furthermore, the intermediate region 4 comprises two first doped regions 5 of the first conductivity type and two second doped regions 6 of the second conductivity type. The first doped region 5 extends from the first side up to the second depth and the second doped region 6 extends from the first side up to the third depth, wherein both depths are smaller than the first depth of the well region 3. For example, the first side is formed from a common plane of the power semiconductor device, facing away from the drain layer 9. In this exemplary embodiment, the second depth and the third depth are equal to one another.

For example, the second depth and the third depth are equal to or deeper than the first depth.

The first doped regions 5 comprise further first dopants being, e.g. n-type dopants. Further, the second doped regions 6 comprise further second dopants being, e.g., p-type dopants. The further first dopants may be the same than the first dopants and the further second dopants may be the same than the second dopants. In addition, a maximum doping concentration of the first doped regions 5 and the second doped regions 6 are at least two times or at least five times higher than a maximum doping concentration of the drift layer 2.

The two first doped regions 5 and the two second doped regions 6 are arranged consecutively alternating along the main extension direction of the intermediate region 4. Each of the first doped regions 5 and the second doped regions 6 are extending over a whole width of the intermediate region 4. This is to say that each of the first doped regions 5 and the second doped regions 6 are in direct contact to the well regions 3.

Such an arrangement of the the first doped regions 5 and the second doped regions 6 results exemplarily in a lower C_{GD} values and, therefore, a better gate control and a faster switching.

In addition, the power semiconductor device 1 according to Figure 1 further comprises a gate 11, as shown in Figure 2. The gate 11 comprises a gate contact 13 and a gate insulator 12. Further, the gate 11 is provided on the intermediate region 4, the two well regions 3 and two of the source regions 7 of different well regions 3. This is to say that the gate 11 overlaps with the intermediate region 4, the two well regions 3 and two of the source regions 7 of different well regions 3 in plan view.

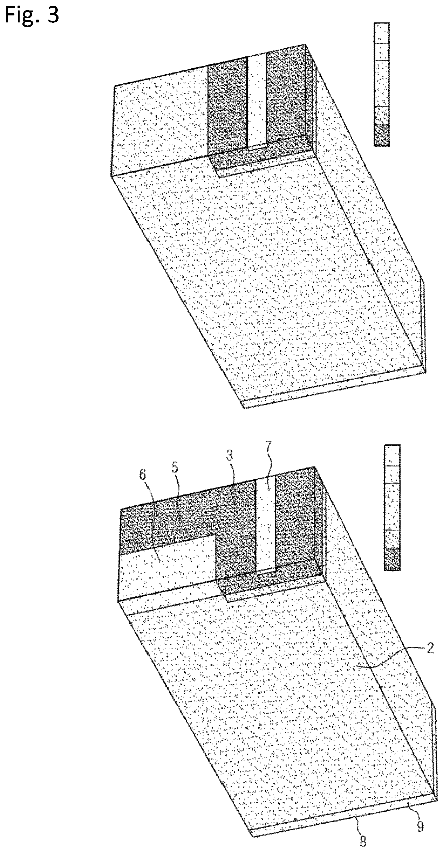

On the upper part of Figure 3, a three dimensional view of a SiC MOSFET with corresponding doping concentrations according to prior art is shown.

On the lower part of Figure 3, a three dimensional view of a power semiconductor device being a SiC MISFET with corresponding doping concentrations according to an exemplary embodiment is shown. The power semiconductor device 1 comprises an intermediate region 4 with a first doped region 5 and a second doped region 6.

A drift layer 2 has, for example, a maximum doping concentration of an n-type conductivity of about 5.10¹² cm⁻³. The first region has a maximum doping concentration of an n-type conductivity of about 6.10¹⁷ cm⁻³ and the region has maximum a doping concentration of a p-type conductivity of about 6.10¹⁷ cm⁻³. A well region 3 has, for example, a maximum doping concentration of a p-type conductivity of about 6.10¹⁷ cm⁻³ which is continuously decreased to about 1·10¹⁴ cm⁻³. Further, a source region 7 has, for example, a maximum doping concentration of an n-type conductivity of about 1·10²⁰ cm⁻³.

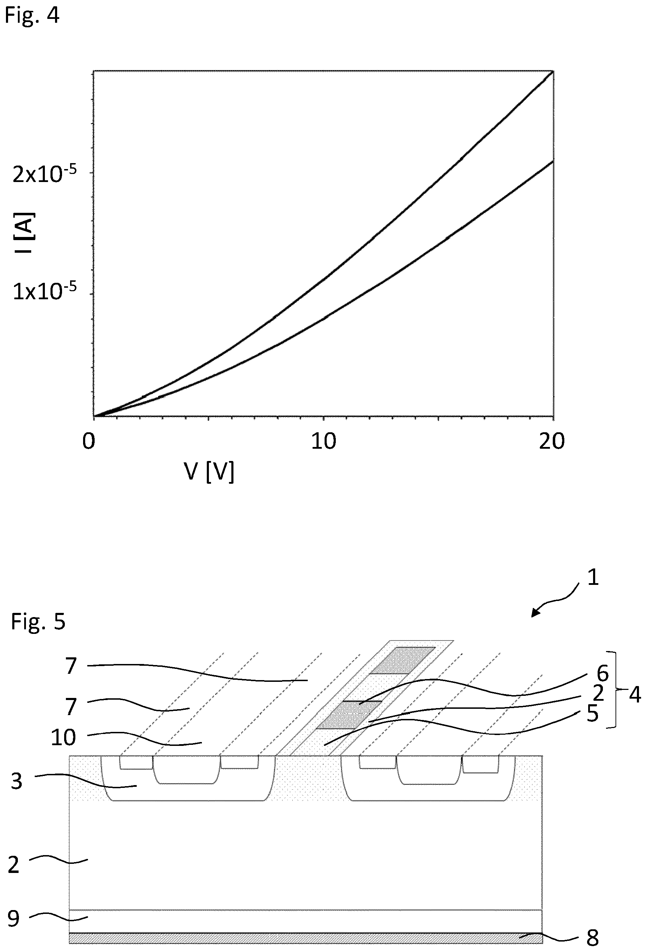

A current, I, in amperes, A, is depicted on the y-axis of the diagram according to Figure 4. Furthermore, a voltage, V, in volt, V, is depicted on the x-axis. The lower I-V curve corresponds to a SiC MOSFET according to prior art without having an intermediate region 4 comprising a first and a second region. Exemplarily, the lower I-V curve is computed dependent on the three dimensional structure of the upper part in Figure 3.

The upper I-V curve corresponds to a power semiconductor device 1 being a SiC MISFET according to an exemplary embodiment. Exemplarily, the upper I-V curve is computed dependent on the three dimensional structure of the lower part in Figure 3.

Due to the intermediate region 4 comprising the first region and the second region of different conductivity types leads to a reduction of the on resistance of the power semiconductor device 1.

In contrast to the power semiconductor device 1 according to the exemplary embodiment of Figure 1, the first doped regions 5 of the first conductivity type and the second doped regions 6 of the second conductivity type do not extend up to the well regions 3 in lateral directions. The first doped regions 5 and the second doped regions 6 have the same width, which is less than the distance between the two neighboured well regions. In this case the drift layer 2 is in between the well regions 3 and the first doped regions 5 and the second doped regions 6.

### Reference symbols

- 1: power semiconductor device
- 2: drift layer
- 3: well region
- 4: intermediate region
- 5: first doped region
- 6: second doped region
- 7: source region
- 8: back metal layer
- 9: drain layer
- 10: plug
- 11: gate
- 12: gate contact
- 13: gate insulator

## Claims

1. A power semiconductor device (1), comprising
- a drift layer (2) of a first conductivity type,
- at least two well regions (3) of a second conductivity type being different from the first conductivity type, and
- at least one intermediate region (4), wherein
- the at least two well regions (3) and the at least one intermediate region (4) are provided at a first side of the power semiconductor device (1),
- the at least one intermediate region (4) is provided between two of the at least two well regions (3), and
- the at least one intermediate region (4) comprises at least one first doped region (5) of the first conductivity type and at least one second doped region (6) of the second conductivity type.

2. The power semiconductor device (1) according the preceding claim, wherein
- the at least one intermediate region (4) extends along a main extension direction, and
- the at least one first doped region (5) and the at least one second doped region (6) are provided consecutively along the main extension direction.

3. The power semiconductor device (1) according to one of the preceding claims, wherein a maximum doping concentration of at least one of the at least one first doped region (5) or the at least one second doped region (6) is at least two times or at least five times higher than a maximum doping concentration of the drift layer (2).

4. The power semiconductor device (1) according to one of the preceding claims, wherein the maximum doping concentration of at least one of the at least one first doped region (5) or the at least one second doped region (6) is at least 1·10¹⁴ cm⁻³ and at most 1.10¹⁸ cm⁻³.

5. The power semiconductor device (1) according to one of the preceding claims, wherein a width of at least one of the at least one first doped region (5) or the at least one second doped region (6) is at least 0.5 µm and at most 5 µm.

6. The power semiconductor device (1) according to one of the preceding claims, wherein a length of at least one of the at least one first doped region (5) or the at least one second doped region (6) is at least 0.5 µm and at most 1.5 µm.

7. The power semiconductor device (1) according to one of the preceding claims, wherein a first depth of the at least two well regions (3) is at most as large as a second depth of the at least one first doped region (5) and as a third depth of the at least one second doped region (6).

8. The power semiconductor device (1) according to claim 7, wherein at least one of the second depth or the third depth are at least 50 nm and at most 1.5 µm.

9. The power semiconductor device (1) according to one of the preceding claims, wherein at least one of the at least one first doped region (5) or the at least one second doped region (6) are in direct contact to the least two well regions (3).

10. The power semiconductor device (1) according to one of the claims 1 to 8, wherein at least one of the at least one first doped region (5) or the at least one second doped region (6) are spaced apart in lateral directions to the least two well regions (3).

11. The power semiconductor device (1) according to one of claims 1 to 7, wherein the at least one second doped region (6) is spaced apart to the at least two well regions (3) in lateral directions.

12. The power semiconductor device (1) according to claim 2, wherein a plurality of first doped regions (5) and a plurality of second doped regions (6) are arranged consecutively alternating along the main extension direction.

13. The power semiconductor device (1) according to one of the preceding claims, wherein
- a gate (11) is provided on the at least one intermediate region (4), and
- a back metal layer (8) is provided on the drift layer (2) at a second side opposite the first side.

14. The power semiconductor device (1) according to one of the preceding claims, further comprising
- at least two source regions (7) of the first conductivity type, wherein
- at least one of the at least two source regions (7) is provided on each of the at least two well regions (3).

15. The power semiconductor device (1) according to claim 13 and 14, wherein the gate (11) overlaps with the at least two source regions (7) at least in places in lateral direction.
